# EUROPEAN PATENT APPLICATION

(11) **EP 4 597 573 A1**
(43) Date of publication of application: **06.08.2025**
(21) Application number: 24155084.7
(22) Date of filing: 31.01.2024
(51) Int. Cl.: H01L 27/02, H01L 21/762

(54) **ESD PROTECTION SEMICONDUCTOR DEVICE AND ESD PROTECTION CIRCUIT**

(71) Applicant: Nexperia B.V., 6534 AB Nijmegen (NL)
(72) Inventor: Mergens, Markus, Hamburg (DE); Ritter, Hans-Martin, Hamburg (DE)
(74) Representative: Pjanovic, Ilija

(57) **Abstract**

The present disclosure relates to a semiconductor electrostatic discharge, ESD, protection device. The present disclosure also relates to electrostatic discharge protection circuit.

An ESD, electrostatic discharge, protection semiconductor device comprising a substrate (1) of a first charge type, an epitaxial layer (2) of a second charge type, an electrical insulation (4), a first contact region (5) of the first charge type, and at least one second contact region (6) of the second charge type, wherein the epitaxial layer (2) is arranged on the substrate (1), wherein the electrical insulation (4) extends from an outer surface (3) of the epitaxial layer (2) toward the substrate (1) such that it creates a plurality of sectors (7) where a current from each one of the sectors (7) must flow toward any other sector (7) through the substrate (1), and wherein the first contact region (5) and the at least one second contact region (6) are formed on the outer surface (3) of the epitaxial layer (2) such that each of the first contact region (5) and at least one second contact region (6) are in different sectors (7).

## Description

### TECHNICAL FIELD

The present disclosure relates to a semiconductor electrostatic discharge, ESD, protection device. The present disclosure also relates to electrostatic discharge protection circuit.

### BACKGROUND OF THE DISCLOSURE

Typically a dual-diode ESD protection scheme is commonly applied for on-chip ESD protection on IC-level. It consists of ESD diodes connected to the VDD and VSS bus, respectively, as well a so-called "ESD (rail) clamp" inserted between the power rails. In this concept, the ESD pulse subjected between one of the RF-IOs and VDD / GND is diverted through a diode to the bus rails. Depending on the stress polarity either a single diode or a diode plus the ESD clamp conduct the stress current between the two pins.

The dual-diode concept is particularly advantageous for high-speed RFIOs, as for example two transceiver pads required for a differential HF interface. This is due to the local low-cap RF-diodes which can be designed for a relatively small load capacitance thus enabling high-speed signals without detrimental distortion. Moreover, the two diodes can offer a superior capacitance linearity C(V) ~ const due to the opposite junction biasing effects reverse vs. forward. This linearity also implies a high potential for low harmonic distortion levels typically required for antenna protection.

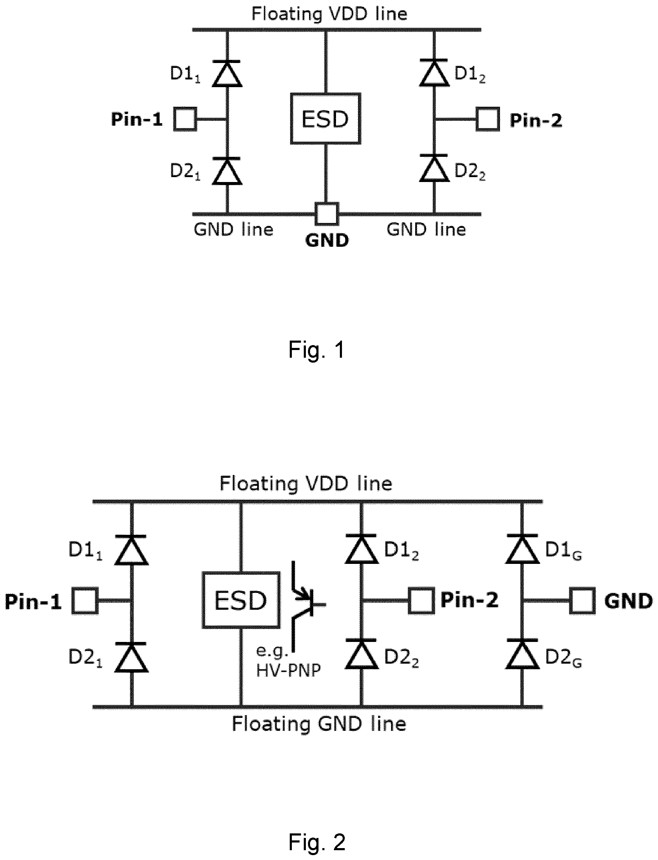

Fig. 1 depicts the typical circuit configuration for a 2-channel ESD off-chip protection, i.e. discrete, with 2 signal and 1 ground pin for a uni-directional and fig. 2 shows the typical circuit configuration for a bi-directional circuit.

For discrete products, uni-directional circuits come with a floating VDD line (typically no dedicated VDD pin) while bi-directional configurations have both rails VDD and GND not directly connected to any pad, i.e. floating lines. In the latter case, the ESD current path between any Pin and GND pad is conducted through two diodes plus the ESD clamp.

Especially for high-voltage applications with high standoff voltages Vrwm ~ 10 to 60V, large vertical bipolar-type devices are commonly applied to dissipate the high-energetic system-level ESD pulses. However, the large active area typically involves excessive junction, metal and other parasitic capacitances such rendering those clamps useless for direct RF pin connection. Here, the dual-diode concept creates a powerful solution by hiding the capacitance of the high-voltage ESD clamp behind two low-cap diodes thus shielding it from the pin and RF PCB lines.

A HV-PNP is indicated in fig. 2 as ESD clamp. The advantage of this device, particularly in a vertical process, is the possibility to architecture it for a high, stable trigger / holding voltage involving only a relatively small voltage snapback, i.e. Vt1 ~ Vh. Such a TLP-IV characteristic complies with the demand of a high Vrwm for high-voltage applications as sketched in Fig. 3 and 4 in a qualitative fashion, cf. dashed line.

However, the disadvantage of the HV-PNP is an inherently high-resistive Rdyn and a lower performance as for instance compared to an NPN in the same area. This is caused by a high power-dissipation in the PNP device due to the high Vhold. Moreover, in the dual-diode concept the diode voltage drop adds to the clamp voltage further deteriorating the overall transient voltage suppression of the product. The innovation combines the HV-PNP + diode to one PNPN device.

Accordingly, it is a goal of the present disclosure to provide the HV-PNP and a diode to one PNPN device. In the present disclosure, this issue of high resistivity and reduced performance is resolved by a frequently current dependent transition of bipolar to PNPN / SCR operation. This means the PNP+diode is converted to a 4-layer PNPN structure working as a (frustrated) SCR.

### SUMMARY OF THE DISCLOSURE

According to a first example of the disclosure, an ESD, electrostatic discharge, protection semiconductor device is disclosed. The ESD protection semiconductor device comprising a substrate of a first charge type, an epitaxial layer of a second charge type, an electrical insulation, a first contact region of the first charge type, and at least one second contact region of the second charge type. The epitaxial layer is arranged on the substrate. The electrical insulation extends from an outer surface of the epitaxial layer toward the substrate such that it creates a plurality of sectors where a current from each one of the sectors must flow toward any other sector through the substrate. The first contact region and the at least one second contact region are formed on the outer surface of the epitaxial layer such that each of the first contact region and at least one second contact region are in different sectors.

Preferably the electrical insulation comprises a deep trench isolation.

Preferably below the first contact region a first contact region well is placed, wherein the first contact region well is of the first charge type.

Preferably below the first contact region, between the substrate and the epitaxial layer, a first buried layer of the first charge type or the second type is placed such that it reaches the electrical insulation, and/or below the second contact region, between the substrate and the epitaxial layer, a second buried layer of a first type is placed such that it reaches the electrical insulation.

Preferably the first charge type is a negative charge, below the first contact region and above the first buried layer there is a first positive buried layer placed such that that it reaches the electrical insulation, and preferably a second positive buried layer, below the first contact region, is placed such that that it reaches the electrical insulation and it is placed in the substrate, wherein below the second contact region, in the epitaxial layer, the first positive buried layer is placed such that it reaches the electrical insulation, and preferably the second positive buried layer, below the second contact region, is placed such that that it reaches the electrical insulation.

Preferably where the first charge type is a positive charge, below the first contact region and above the first buried layer there is a negative buried layer placed such that that it reaches the electrical insulation, and preferably below the second contact region, in the epitaxial layer, a second contact region well is placed.

Preferably a doping concentration in the epitaxial layer is lower than 1e15 cm-3, preferably lower than 1e14 cm-3, and/or a doping concentration in in the substrate is higher than 1e16 cm-3, preferably higher than 1e17 cm-3.

Preferably a base contact region is placed near the first contact region, within the same sector, such that between the base contact region and the first contact region there is the epitaxial layer and such that current between the first contact region and the base contact region may flow through the epitaxial layer.

According to a second example of the disclosure an ESD, electrostatic discharge, protection circuit comprising an ESD protection device is disclosed. The ESD protection device comprises at least two second contact regions and at least two diodes. Each one of the at least two diodes, a first contact region and at least two second contact regions are in different sectors. Each diode is made of a first diode contact region of a second charge type and at least one second diode contact region of a first charge type. The first diode contact region and the second diode contact region are formed on an outer surface of an epitaxial layer such that the first diode contact region and the second diode contact region are separated with the epitaxial layer. The ESD protection device further comprises at least two junctions. Each of the junction is galvanically separated from each other. Each of the junction is connected galvanically, with a connector, to one of the second contact regions and to the one of the diodes, namely to the at least one of the second diode contact region. Each of the first diode contact region and the first contact region are connected galvanically with the connector.

Preferably it further comprising a ground junction connected to the first diode contact region and the first contact region, wherein the first charge type is a negative charge.

Preferably one of the junction is a ground junction and wherein the first charge type is a positive charge.

Preferably the sector which comprises the diode is directly adjacent to the sector which comprises the first contact region.

Preferably the sector which comprises the second contact region is directly adjacent to the sector which comprises the first contact region.

Preferably the sector which comprises the diode further comprises a diode contact well which is placed such that it is below at least one second diode contact region, preferably the diode contact well is placed under the first diode contact region.

Preferably in the sector with the diode, between the substrate and the epitaxial layer, a diode buried layer of the second charge type is placed such that it reaches an electrical insulation.

### BRIEF DESCRIPTION OF THE DRAWINGS

The disclosure will now be discussed with reference to the drawings, where:
Figure 1 shows a prior art uni-directional circuit for with a dual-diode concept for discrete ESD protection,
Figure 2 shows a prior art bi-directional circuit for with a dual-diode concept for discrete ESD protection,

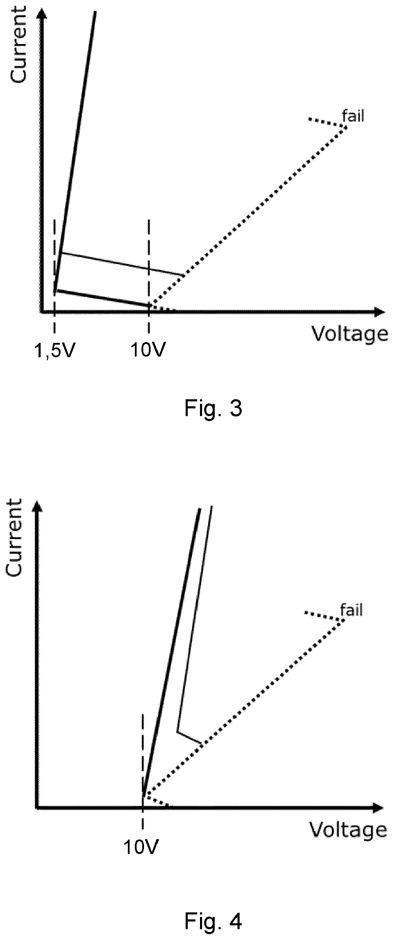

Figure 3 shows a typical TLP-IV characteristic of a high-voltage PNP with a diode with a holding voltage Vh>10V for SCR,
Figure 4 shows a typical TLP-IV characteristic of a high-voltage PNP with a diode with holding voltage Vh>10V for "frustrated" SCR,

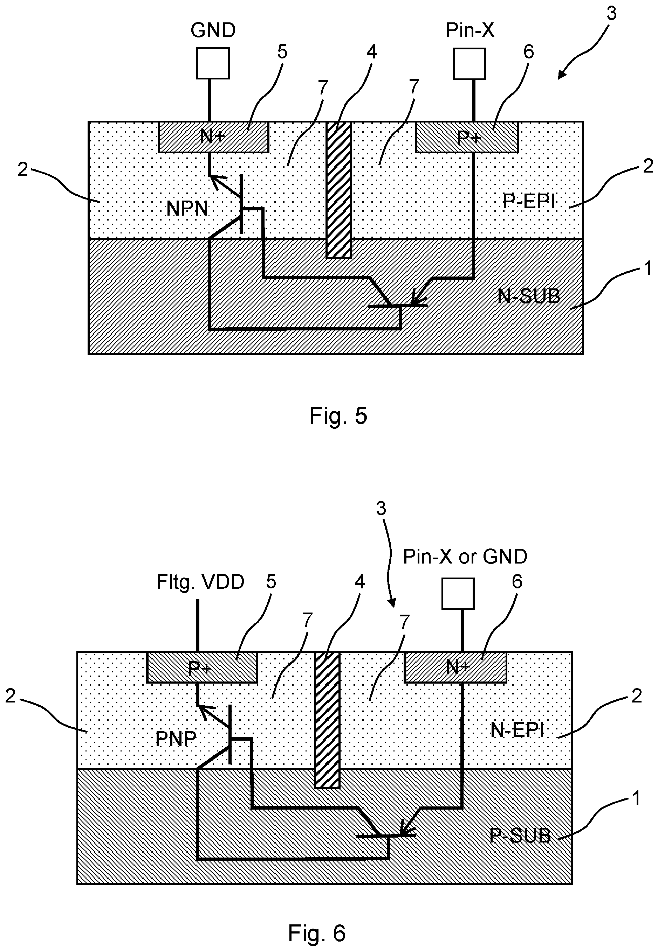

Figure 5 shows a Uni-directional dual-diode concept with NPN rail-clamp and mixed lateral / vertical diodes in P-EPI / N-SUB / NWELL technology for 2-channel applications (e.g. differential RF-pins). The vertical NPN clamp and individual vertical diode D1X form a four-layer structure, i.e. SCR, through the N-Substrate
Figure 6 shows a Dual-diode concept with PNP rail-clamp and lateral (D1_{X}) / vertical (D2_{X}) diodes in N-EPI / P-SUB / PWELL technology for bi-directional 2-channel applications (e.g. differential RF-pins). The vertical PNP clamp and individual vertical diode D2x form a four-layer structure, i.e. SCR, through the P-Substrate

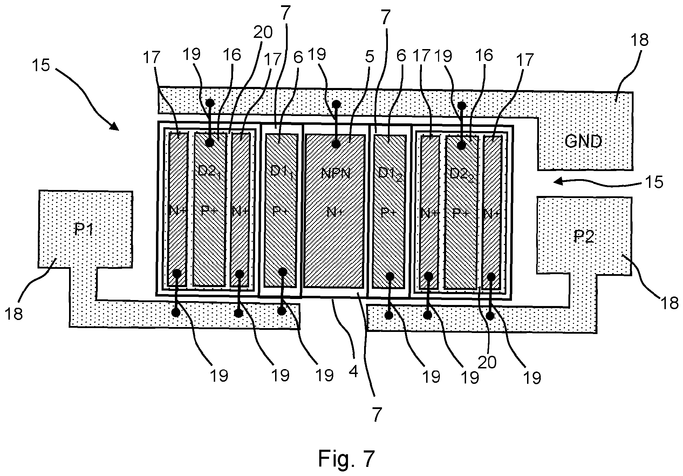

Figure 7 shows a Embodiment - layout view: Dual-diode concept with vertical NPN rail-clamp and mixed lateral diodes in Nwell (D2X) and vertical (D1X) diodes in a P-EPI / N-SUB technology for uni-directional 2-channel application. An Nwell is required for lateral diode isolation in the P-EPI.

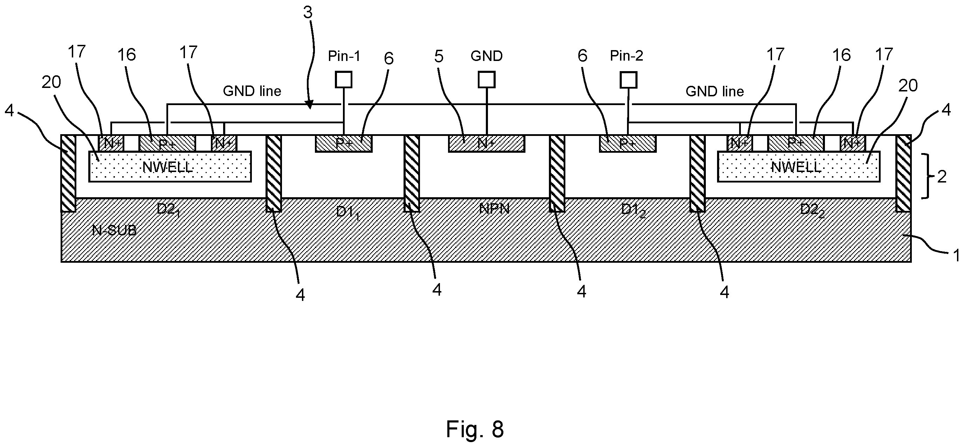

Figure 8 shows a Cross-section of layout in Figure 7.

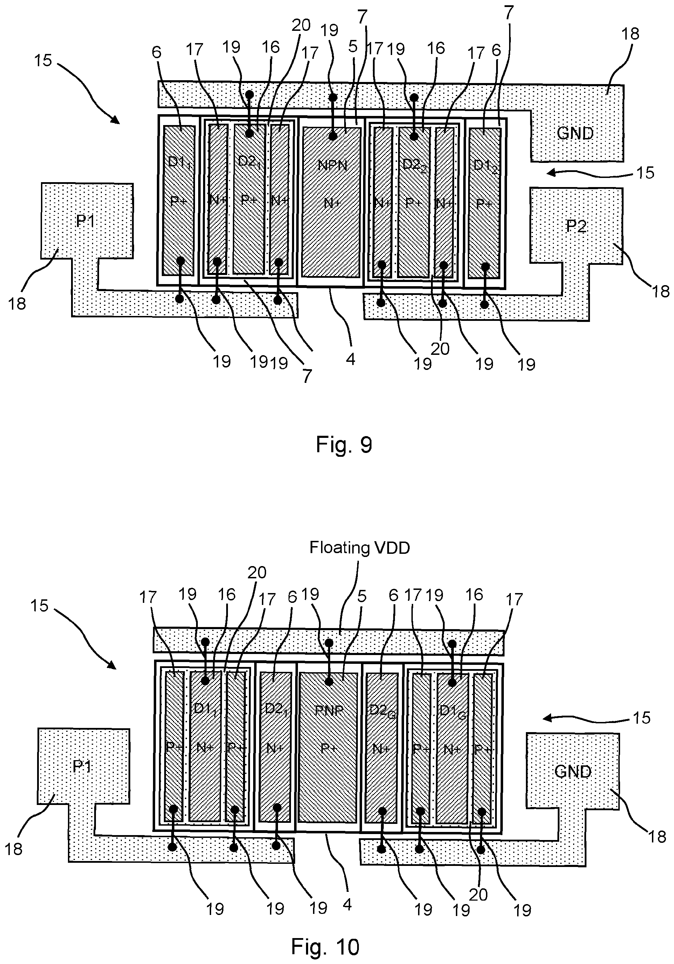

Figure 9 shows a Embodiment - layout: dual-diode concept with modified floor-planning for increased distance between vertical diode and PNP and maximum distance between the vertical diodes D11 and D12.
Figure 10 shows a Embodiment: Dual-diode concept with vertical PNP rail-clamp and mixed lateral diodes (D1X) in Pwell and vertical (D2X) diodes in a N-EPI / P-SUB technology for bi-directional applications. Only one channel is shown here. A Pwell is required for lateral diode isolation in the N-Epi.

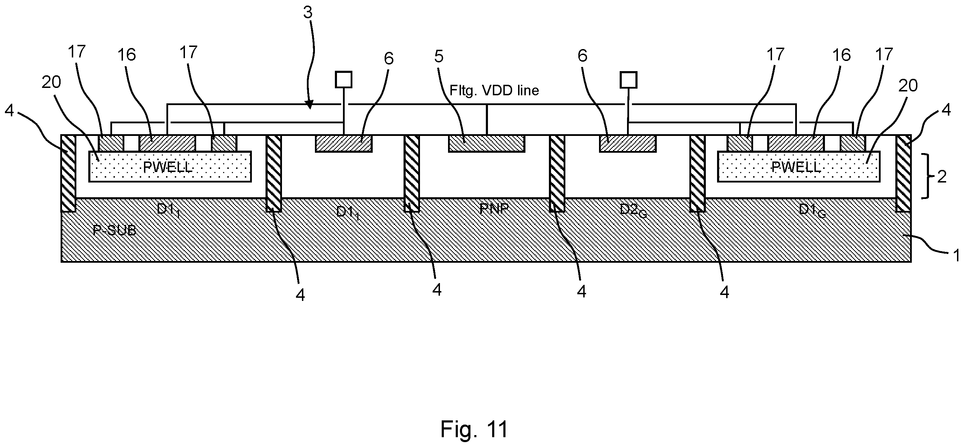

Figure 11 shows a Cross-section of layout in above Figure 10

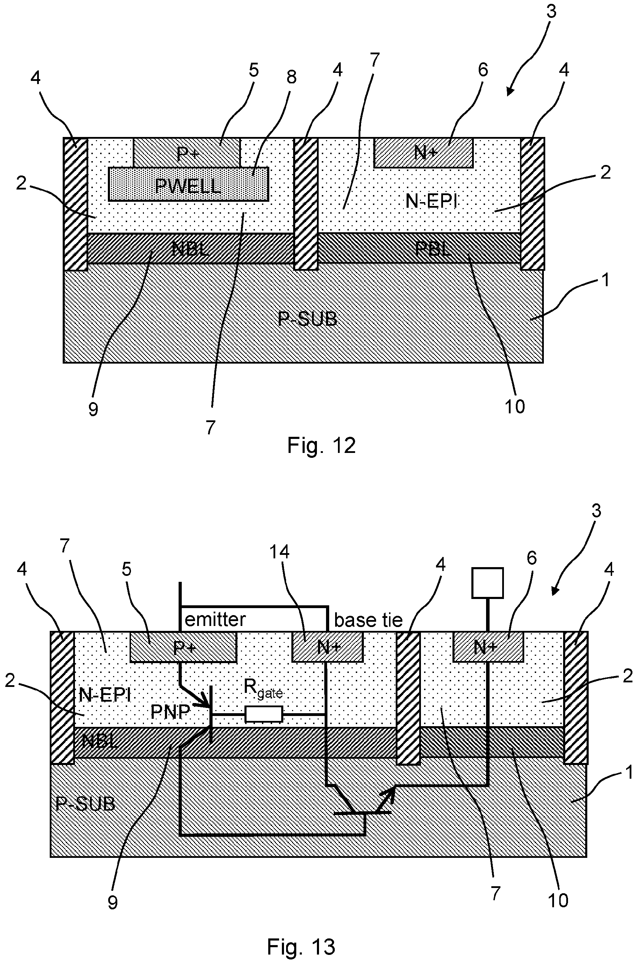

Figure 12 shows a Cross-section of a) vertical PNP and b) vertical diode with additional Pwell, N-type buried layer (NBL), and P-type buried layer (PBL)
Figure 13 shows a Cross-section of a vertical PNP bipolar clamp (cf. also Figure 5) including N+ base-tie translating into a gate resistor Rgate in the diode-clamp combined SCR.

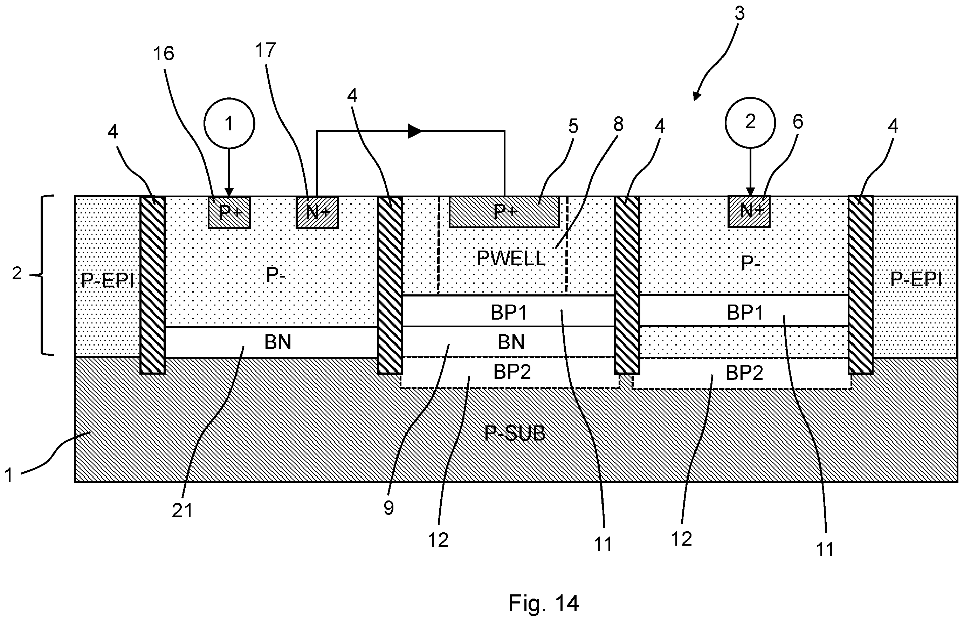

Figure 14 shows an embodiment with low capacity diodes with P type substrate

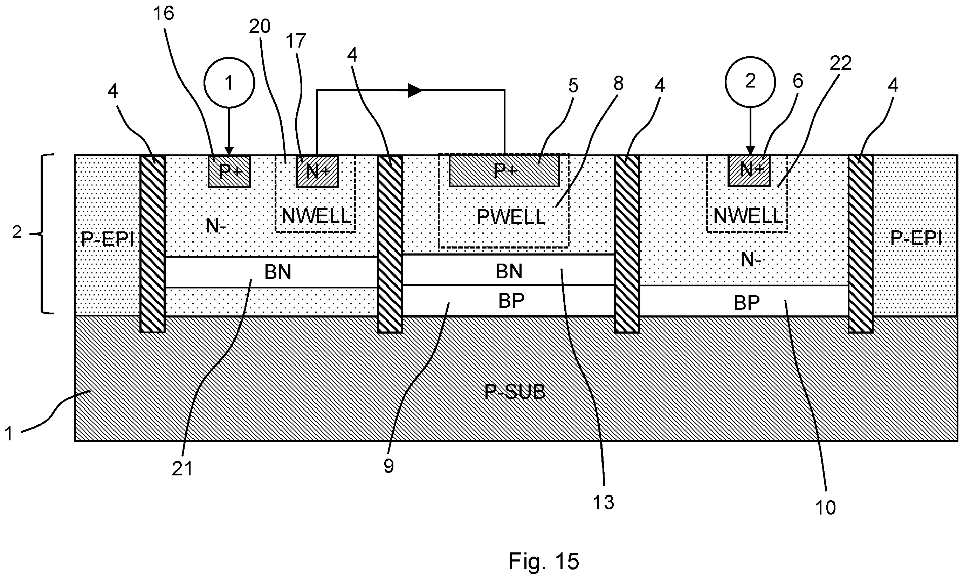

Figure 15 shows an embodiment with low capacity diodes with N type substrate

### DETAILED DESCRIPTION OF THE DISCLOSURE

For a proper understanding of the disclosure, in the detailed description below corresponding elements or parts of the disclosure will be denoted with identical reference numerals in the drawings.

Key of the present disclosure is a modified dual-diode concept mixing adequate lateral and vertical diodes while using a vertical bipolar ESD clamp. The vertical diodes at each pin couple to the bipolar clamp through the substrate to establish a 4-layer structure and thus a certain SCR action. Note that an electrical insulation 4, preferably a deep trench, reaching through to a substrate 1 is crucial in this concept for laterally isolated circuit elements.

Fig. 5 shows a bi-directional circuit with PNP clamp in a N-EPI / P-SUB technology. As indicated in the schematic, the substrate 1 can be considered either as VDD rail or as GND rail. The cross-sections highlight the crucial PNPN coupling of the vertical diode to the clamp through the corresponding substrate. It should be noted that the term "vertical diode" is used for structure made of the substrate 1, an epitaxial layer 2 and a second contact region 6.

In a first exemplary embodiment an ESD, electrostatic discharge, protection semiconductor device comprising a substrate 1 of a first charge type, an epitaxial layer 2 of a second charge type, an electrical insulation 4, a first contact region 5 of the first charge type, and at least one second contact region 6 of the second charge type. The epitaxial layer 2 is arranged on the substrate 1. The electrical insulation 4 extends from an outer surface 3 of the epitaxial layer 2 toward the substrate 1 such that it creates a plurality of sectors 7 where a current from each one of the sectors 7 must flow toward any other sector 7 through the substrate 1. The first contact region 5 and the at least one second contact region 6 are formed on the outer surface 3 of the epitaxial layer 2 such that each of the first contact region 5 and at least one second contact region 6 are in different sectors 7. Such a device is shown on fig. 5, where the substrate 1 is negatively charged, and on fig. 6, where the substrate 1 is positively charged.

It is important to note that the substrate coupling strongly depends on the substrate doping concentration, the distance between vertical diode (with an inherent lateral bipolar) and bipolar clamp as well as on the device geometry. Preferably a doping concentration in the epitaxial layer 2 is lower than 1e15 cm-3, preferably lower than 1e14 cm-3, and/or a doping concentration in in the substrate 1 is higher than 1e16 cm-3, preferably higher than 1e17 cm-3 - it should be noted that a lower capacity will be achieved when the epitaxial layer 2 is lowly doped. In a diode 15 the vertical distance between the N-diffusion and the highly doped p-substrate should be large enough - preferably turn, even more preferably 3 um. The lower the substrate doping and the closer the distance of abovementioned elements, the stronger the PNP-NPN coupling. This means the device behavior tends towards real low-Vhold SCR action as indicated in Fig. 3. On the other hand, tuning these parameters for instance by a sufficiently increased substrate doping the coupling between PNP and NPN can be reduced in a way that no latch and no deep snapback occurs anymore. A weak coupling would result in a NPN supported PNP action, i.e. the NPN provides part of the PNP base current thus making it more efficient compared to avalanche generated base self-biasing in the device.

Fig. 7 displays a fully symmetrical layout of an electrostatic discharge protection circuit embodiment related to Fig. 5 and Fig. 8 depicts the cross-section of the layout in Fig. 7. The ESD, electrostatic discharge, protection circuit comprising an ESD protection device, wherein the ESD protection device comprises at least two second contact regions 6 and at least two diodes 15. Each one of the at least two diodes 15, a first contact region 5 and at least two second contact regions 6 are in different sectors 7. Each diode 15 is made of a first diode contact region 16 of a second charge type and at least one second diode contact region 17 of a first charge type. The first diode contact region 16 and the second diode contact region 17 are formed on an outer surface 3 of an epitaxial layer 2 such that the first diode contact region 16 and the second diode contact region 17 are separated with the epitaxial layer 2. There are at least two junctions 18, each of the junction 18 is galvanically separated from each other. Each of the junction 18 is connected galvanically, with a connector 19, to one of the second contact regions 6 and to the one of the diodes 15, namely to the at least one of the second diode contact region 10. Each of the first diode contact region 16 and the first contact region 5 are connected galvanically with the connector 19. The ESD protection device according to claim 4, wherein, where the first charge type is a negative charge, below the first contact region 5 and above the first buried layer 9 there is a first positive buried layer 11 placed such that that it reaches the electrical insulation 4, and preferably a second positive buried layer 12, below the first contact region 5, is placed such that that it reaches the electrical insulation 4 and it is placed in the substrate 1, wherein below the second contact region 6, in the epitaxial layer 2, the first positive buried layer 11 is placed such that it reaches the electrical insulation 4, and preferably the second positive buried layer 12, below the second contact region 6, is placed such that that it reaches the electrical insulation 4.

Preferably the sector 7 which comprises the diode 15 further comprises a diode contact well 20 which is placed such that it is below at least one second diode contact region 17, preferably the diode contact well 20 is placed under the first diode contact region 16. the diode contact well 20 isolates the diode 15 from P-EPI.

In one exemplary embodiment shown in fig. 9 the sector 7 which comprises the diode 15 is directly adjacent to the sector 7 which comprises the first contact region 5. In other exemplary embodiment shown in fig. 7 sector 7 which comprises the second contact region 6 is directly adjacent to the sector 7 which comprises the first contact region 5.The diodes 15, when placed in minimum distance to the centered NPN clamp, form the most efficient PNP and NPN coupling, however both designs may be used to adjust the overall characteristics of the device. Exchanging the position of lateral and vertical diodes can be advantageous for two reasons:
- The larger distance of D1X to the NPN results in a weaker PNP-NPN coupling due to the increased NPN base length (with higher recombination rate of minorities). Consequently, bipolar coupling is weakened, a means to achieve frustrated SCR action with high holding voltage.
- Maximizing the distance between both vertical diodes D11 and D12 minimizes a potentially detrimental pin-pin cross-coupling through the substrate 1.

Fig. 10 depicts a layout embodiment related to Fig. 6, however, for simplicity reason only one pin P1 (i.e. single channel) is shown. A second channel can for example be introduced by mirroring the layout at the floating VDD line upwards. Other ways are possible as well. The vertical diodes 15 are placed adjacent and at minimum distance to the centered PNP clamp for strongest coupling between NPN and PNP. Of course, the distance can be varied as also shown in Figure 7 and 9. In this embodiment the first charge type is a positive charge, below the first contact region 5 and above the first buried layer 9 there is a negative buried layer 13 placed such that that it reaches the electrical insulation 4, and preferably below the second contact region 6, in the epitaxial layer 2, a second contact region well 22 is placed.

All lateral and vertical circuit elements shown above can be realized in various architectures e.g. using additional wells and buried layer as exemplary illustrated for vertical PNP and vertical diode in Fig. 12. In one exemplary embodiment below the first contact region 5 a first contact region well 8 is placed. The first contact region well 8 is of the first charge type. In another exemplary embodiment below the first contact region 5, between the substrate 1 and the epitaxial layer 2, a first buried layer 9 of the first charge type or the second type is placed such that it reaches the electrical insulation 4, and/or below the second contact region 6, between the substrate 1 and the epitaxial layer 2, a second buried layer 10 of a first type is placed such that it reaches the electrical insulation 4. In yet another exemplary embodiment the sector 7 with the diode 15, between the substrate 1 and the epitaxial layer 2, a diode buried layer 21 of the second charge type is placed such that it reaches an electrical insulation 4. A higher doping in the coupling path will reduce the coupling and 'frustrate' the SCR more. Therefore buried layers, that is the diode buried layer 21, the negative buried layer 13, the first buried layer 9, the second buried layer 10 and negative buried layer 13, and well, the first contact region well 8, may be used to tune the coupling, especially for substrates that are not heavily doped.

It should be noted that the first charge and the second charge may be either a positive charge or a negative charge. It should also be noted that both may have the same charge type at the same time. Some additional problems may appear which may be overcome with the additional buried layers. A first problem: short from diode 15 to substrate 1, which may be overcome with the isolation made of a buried layer. A second problem: risk of punch between the diode 15 and the substrate 1, especially for lowly doped epitaxial layer 2. In such a case a punch stopper is recommended. Therefore buried layer, that is the diode buried layer 21, and wells, namely the diode contact well 20 and the first contact region well 8, may be used The low capacity solutions requires buried layers. It should also be noted that N and P-wells, that is the first contact region well 8 and the diode contact well 20, are also possible, but will cause a higher capacity for the diodes 15.

Additional buried layers may also be used for tuning the breakdown voltage and the snap-back of the transistor. The breakdown of the transistor is defined by the doping at the base collector junction and thus the additional buried layer may be used to tune it. Any high doping in the base region will reduce the current gain of the transistor, consequently the 'depth' of the snap-back will be smaller - an additional buried layer will tune the gain of the transistor. Therefore buried layers, that is the diode buried layer 21, the negative buried layer 13, the first buried layer 9 and negative buried layer 13, and well, the first contact region well 8, may be used.

The embodiment in Fig. 13 contains an additional N+ base-tie for the vertical PNP clamp forming an inherent emitter-base resistance. In the SCR, this translates into a so-called gate resistance Rgate. It can be used to adjust the ESD trigger current / voltage, e.g. by changing the distance or pitch between P+ emitter and N+ base-tie. In the exemplary embodiment a base contact region 14 is placed near the first contact region 5, within the same sector 7, such that between the base contact region 14 and the first contact region 5 there is the epitaxial layer 2 and such that current between the first contact region 5 and the base contact region 14 may flow through the epitaxial layer 2.

### LIST OF REFERENCE NUMERALS USED

- 1: substrate
- 2: epitaxial layer
- 3: outer surface
- 4: electrical insulation
- 5: first contact region
- 6: second contact region
- 7: sector
- 8: first contact region well
- 9: first buried layer
- 10: second buried layer
- 11: first positive buried layer
- 12: second positive buried layer
- 13: negative buried layer
- 14: base contact region
- 15: diode
- 16: first diode contact region
- 17: second diode contact region
- 18: junction
- 19: connector
- 20: diode contact well
- 21: diode buried layer
- 22: second contact region well

## Claims

1. An ESD, electrostatic discharge, protection semiconductor device comprising:
a substrate (1) of a first charge type;
an epitaxial layer (2) of a second charge type;
an electrical insulation (4);
a first contact region (5) of the first charge type; and
at least one second contact region (6) of the second charge type,
wherein the epitaxial layer (2) is arranged on the substrate (1),
wherein the electrical insulation (4) extends from an outer surface (3) of the epitaxial layer (2) toward the substrate (1) such that it creates a plurality of sectors (7) where a current from each one of the sectors (7) must flow toward any other sector (7) through the substrate (1);
and wherein the first contact region (5) and the at least one second contact region (6) are formed on the outer surface (3) of the epitaxial layer (2) such that each of the first contact region (5) and at least one second contact region (6) are in different sectors (7).

2. The ESD protection device according to claim 1, wherein the electrical insulation (7) comprises a deep trench isolation.

3. The ESD protection device according to claim 1 or 2, wherein below the first contact region (5) a first contact region well (8) is placed, wherein the first contact region well (8) is of the first charge type.

4. The ESD protection device according to anyone of the previous claims, wherein below the first contact region (5), between the substrate (1) and the epitaxial layer (2), a first buried layer (9) of the first charge type or the second type is placed such that it reaches the electrical insulation (4), and/or below the second contact region (6), between the substrate (1) and the epitaxial layer (2), a second buried layer (10) of a first type is placed such that it reaches the electrical insulation (4).

5. The ESD protection device according to claim 4, wherein, where the first charge type is a negative charge, below the first contact region (5) and above the first buried layer (9) there is a first positive buried layer (11) placed such that that it reaches the electrical insulation (4), and preferably a second positive buried layer (12), below the first contact region (5), is placed such that that it reaches the electrical insulation (4) and it is placed in the substrate (1), wherein below the second contact region (6), in the epitaxial layer (2), the first positive buried layer (11) is placed such that it reaches the electrical insulation (4), and preferably the second positive buried layer (12), below the second contact region (6), is placed such that that it reaches the electrical insulation (4).

6. The ESD protection device according to claim 4, wherein, where the first charge type is a positive charge, below the first contact region (5) and above the first buried layer (9) there is a negative buried layer (13) placed such that that it reaches the electrical insulation (4), and preferably below the second contact region (6), in the epitaxial layer (2), a second contact region well (22) is placed.

7. The ESD protection device according to anyone of the previous claims, wherein a doping concentration in the epitaxial layer (2) is lower than 1e15 cm⁻³, preferably lower than 1e14 cm⁻³, and/or a doping concentration in in the substrate (1) is higher than 1e16 cm⁻³, preferably higher than 1e17 cm⁻³.

8. The ESD protection device according to anyone of the previous claims, wherein a base contact region (14) is placed near the first contact region (5), within the same sector (7), such that between the base contact region (14) and the first contact region (5) there is the epitaxial layer (2) and such that current between the first contact region (5) and the base contact region (14) may flow through the epitaxial layer (2).

9. An ESD, electrostatic discharge, protection circuit comprising an ESD protection device according to anyone of claim 1-8,
wherein the ESD protection device comprises at least two second contact regions (6) and at least two diodes (15),
wherein each one of the at least two diodes (15), a first contact region (5) and at least two second contact regions (6) are in different sectors (7),
wherein each diode (15) is made of a first diode contact region (16) of a second charge type and at least one second diode contact region (17) of a first charge type, wherein the first diode contact region (16) and the second diode contact region (17) are formed on an outer surface (3) of an epitaxial layer (2) such that the first diode contact region (16) and the second diode contact region (17) are separated with the epitaxial layer (2),
wherein further comprising at least two junctions (18), each of the junction (18) is galvanically separated from each other, wherein each of the junction (18) is connected galvanically, with a connector (19), to one of the second contact regions (6) and to the one of the diodes (15), namely to the at least one of the second diode contact region (10),
wherein each of the first diode contact region (16) and the first contact region (5) are connected galvanically with the connector (19).

10. The ESD protection circuit according to claim 9, wherein it further comprising a ground junction connected to the first diode contact region (16) and the first contact region (5), wherein the first charge type is a negative charge.

11. The ESD protection circuit according to claim 9, wherein one of the junction (18) is a ground junction and wherein the first charge type is a positive charge.

12. The ESD protection circuit according to anyone of claim 9-11, wherein the sector (7) which comprises the diode (15) is directly adjacent to the sector (7) which comprises the first contact region (5).

13. The ESD protection circuit according to anyone of claim 9-12, wherein the sector (7) which comprises the second contact region (6) is directly adjacent to the sector (7) which comprises the first contact region (5).

14. The ESD protection circuit according to anyone of claim 9-13, wherein the sector (7) which comprises the diode (15) further comprises a diode contact well (20) which is placed such that it is below at least one second diode contact region (17), preferably the diode contact well (20) is placed under the first diode contact region (16).

15. The ESD protection circuit according to anyone of claim 9-14, wherein in the sector (7) with the diode (15), between the substrate (1) and the epitaxial layer (2), a diode buried layer (21) of the second charge type is placed such that it reaches an electrical insulation (4).
